(19) **Europäisches Patentamt / European Patent Office / Office européen des brevets**

(11) **EP 1 455 453 B1**

(12) **EUROPEAN PATENT SPECIFICATION**

(45) Date of publication and mention
of the grant of the patent:
**05.09.2007 Bulletin 2007/36**

(51) Int Cl.:
*H03K 17/567* *(2006.01)*     *H03K 17/64* *(2006.01)*

(21) Application number: **03425141.3**

(22) Date of filing: **05.03.2003**

(54) **Driving circuit for a control terminal of a bipolar transistor in emitter-switching configuration having a resonant load**

Ansteuerschaltung für einen Steueranschluss eines Bipolartransistors mit geschaltetem und einer resonanten Last

Circuit de commande pour une borne de commande d'un transistor bipolaire à émetteur commuté avec une charge résonnante

(84) Designated Contracting States:
**DE FR GB IT**

(43) Date of publication of application:
**08.09.2004 Bulletin 2004/37**

(73) Proprietor: **STMicroelectronics S.r.l.**
**20041 Agrate Brianza (Milano) (IT)**

(72) Inventors:
• **Scollo, Rosario**
**95045 Misterbianco (Catania) (IT)**

• **Buonomo, Simone**
**96011 Augusta (Siracusa) (IT)**

(74) Representative: **Ferrari, Barbara**
**Botti & Ferrari S.r.l.,**
**Via Locatelli, 5**
**20135 Milano (IT)**

(56) References cited:
**US-A- 4 695 770**

EP 1 455 453 B1

## Description

Field of application

The present invention relates to a driving circuit for a control terminal of a bipolar transistor in the emitter-switching configuration with resonant load.

More specifically, the invention relates to a driving circuit for a control terminal of a bipolar transistor inserted, in the emitter-switching configuration, between a resonant load and a voltage reference, said driving circuit comprising at least a capacitor connected between said control terminal and said voltage reference.

The invention particularly relates, but not exclusively, to a high breakdown voltage bipolar transistor being cascode-connected to a low voltage MOS transistor in the so-called emitter-switching configuration and the following description is made with reference to this field of application for convenience of illustration only.

Prior art

As it is well known, a so-called emitter-switching circuit configuration comprises a cascode connection of a bipolar transistor having a high breakdown voltage and of a low voltage MOSFET power transistor.

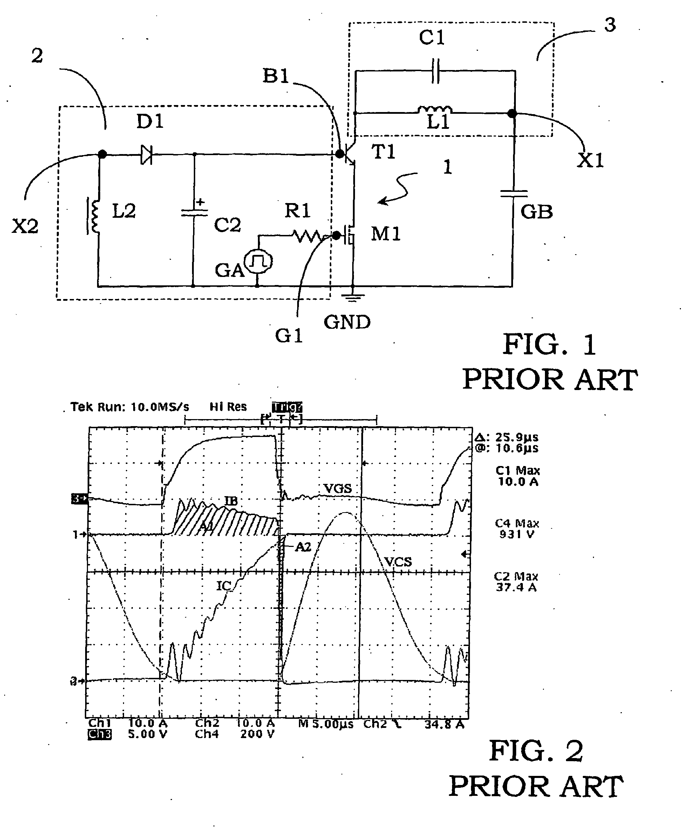

Such a configuration is schematically shown in figure 1 and globally indicated with 1. The emitter-switching configuration 1 comprises a bipolar transistor T1 and a MOS transistor M1, cascode-connected to each other, connected between a load 3 and a voltage reference, particularly the ground GND.

The emitter-switching configuration 1 provides that the bipolar transistor T1 is of the HV (High Voltage) type, i.e. a high breakdown voltage transistor, while the MOS transistor M1 is of the LV (Low Voltage) type, i.e. a low breakdown voltage transistor.

The bipolar transistor T1 has a collector terminal connected to the load 3 and a control or base terminal B1 connected to a driving circuit 2.

The load 3 is of the resonant or quasi-resonant type and it comprises an inductor L1 corresponding to the primary of a transformer and a capacitor C1 inserted., in parallel with the inductor L1, between the collector terminal of the bipolar transistor T1 and a supply circuit node X1, connected in turn to a generator GB of a supply voltage Vcc, applied to the supply circuit node X1.

The capacitor C1 is chosen so as to resonate with the inductor L1 in correspondence with the operating frequency of the application concerned.

The MOS transistor M1 has in turn a control or gate terminal connected to the driving circuit 2.

The driving circuit 2 comprises:

- a first resistive element R1 connected to the gate terminal G1 of the MOS transistor M1 and, by means of a voltage pulse generator GA, to ground GND;

- an electrolytic capacitor C2 connected between the base terminal B1 of the bipolar transistor T1 and the ground GND and having at the terminals thereof a voltage value equal to VB;

- a second inductor L2 corresponding to the secondary of a transformer and inserted between a second circuit node X2 and the ground GND; and

- a diode D1, inserted between the base terminal B1 of the bipolar transistor T1 and the second circuit node X2.

The emitter-switching configuration, known for a long time to the skilled in the art, is at present particularly interesting due to the marketing of bipolar transistors having a square RBSOA [Reverse Biased Safe Operating Area] (in the emitter-switching configuration) with a current near to the peak current and a voltage equal to the breakdown voltage BVCES between the collector and emitter terminals when the base terminal is short-circuited with the emitter terminal [Breakdown Voltage Collector-Emitter Short], as well as of MOS power transistors having a very low drain-source resistance value in conduction conditions, $R_{DSON}$, and being thus almost similar to ideal switches.

The emitter-switching configuration main advantages are, as everybody knows, an extremely low in-conduction voltage fall (typical of bipolar transistors) and a high turn-off speed.

In fact, when turning off, the current outputted from the bipolar transistor base terminal is equal to the collector terminal current of this transistor, i.e. a very high value current. This causes a drastic reduction both of the storage time and of the fall time, allowing the emitter-switching configuration to operate even at frequencies of 150 kHz.

All the applications satisfying the following relation will now be considered:

$$I_{BOFF} * t_{storage} >> I_{BON} * t_{on}$$

Where
$I_{BOFF}$ is the base current value of the bipolar transistor T1 in the turn-off step;
$t_{storage}$ is the storage time;
$I_{BON}$ is the base current value of the bipolar transistor T1 in the conduction step, and
$T_{on}$ is the conduction time

In particular, the condition (1) occurs when the operating frequency is relatively low (i.e. lower than 60 kHz) and, all the more reason, if high currents (higher than ten Amperes) are being dealt with.

This is for example the case of so-called rice cooker devices, whose waveforms for an operating frequency of 35 kHz and with a highest collector current of about 40 A are indicated by way of example in figure 2.

In this case, the driving circuit of figure 1 is simple but expensive. In fact, it is necessary to provide a middle power supplier (about 10 W in the case of the example of figure 1).

In fact it is worth noting that only the secondary part of the relevant power supplier has been indicated in figure 1 for convenience of illustration. The power supplier is essential since the base terminal B1 of the bipolar transistor T1 must be supplied with a current IB which, in the case being here examined, and in all similar cases, cannot be provided by recovering energy during the turn-off, as it happens instead in other applications.

For a better understanding of this concept it must be observed in figure 2 that the area A2, representing the amount of charge recovered during the turn-off, is far lower than the area A1 representing, instead, the amount of charge required by the base terminal B1 to make the emitter-switching configuration 1 operate correctly.

This known solution is thus effective from the performance point of view, but it is very expensive.

Other known solutions provide the use of IGBT or MOS power transistors.

When the following conditions occur:

Resonant or quasi-resonant load

High collector current (> 10 A)

Relatively low frequency (< 60 kHz)

Not too low Duty Cycle (> 15%)

the devices formed by IGBT power transistors are particularly suitable.

In fact, in view of voltage levels, current values and the relatively low frequency, choosing a MOS power transistor (PowerMOS) would be particularly expensive.

In particular, it is known that a MOS power transistor able to support higher voltages than 1000 V and to conduct a high current would involve a silicon area being from 5 to 10 times higher than an IGBT transistor or a bipolar transistor having the same breakdown voltage value and current capacity value.

Moreover in that case the use of a MOS power transistor would be unnecessary since the switching speed thereof, which is instead essential at higher frequencies, would not be fully exploited.

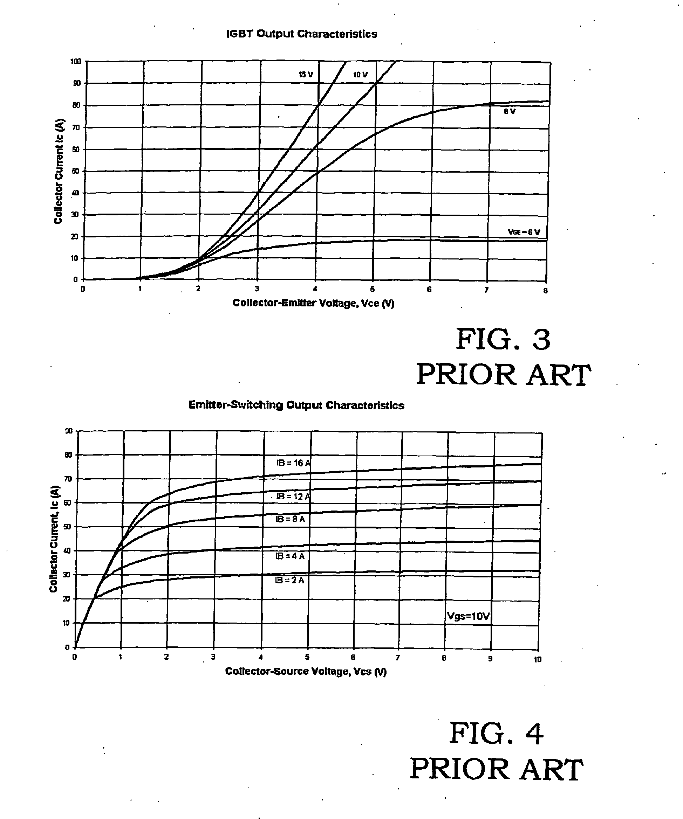

It is also known that a bipolar transistor in the emitter-switching configuration has highly competitive turn-off times and, in particular, fall times comparable to those obtained with a MOS power transistor, as well as a very low in-conduction fall, the lowest obtainable with power devices, as it can be seen in figure 4.

By using an IGBT transistor a relatively low in-conduction voltage fall is similarly obtained, as underlined by the output features shown in figure 3. The IGBT transistor has however a current queue when turning off, a phenomenon which can be completely deleted by using a bipolar transistor in the emitter-switching configuration (by conveniently driving the base terminal), as shown in figure 2.

The use of a bipolar transistor in the emitter-switching configuration has thus only a limit linked to the base terminal driving current.

The technical problem underlying the present invention is to provide a driving circuit for a control terminal of a bipolar transistor in the emitter-switching configuration with resonant load, having such structural and functional characteristics as allow the base current of the bipolar transistor comprised in this configuration to be correctly modulated, overcoming therefore the limits and drawbacks still affecting cascode configuration driving circuits for resonant applications according to the prior art.

Summary of the invention

The solutive idea underlying the present invention is to exploit, in order to supply the bipolar transistor base terminal, the energy being usually transferred from the inductor to the resonance capacitor in the first part of the turn-off step.

On the basis of this solutive idea the technical problem is solved by a driving circuit as previously indicated and defined in the characterising part of claim 1.

The technical problem is also solved by a driving method as previously indicated and defined in the characterising part of claim 6.

The features and advantages of the driving circuit and method according to the invention will be apparent from the following description of an embodiment thereof given by way of non-limiting example with reference to the attached drawings.

Brief description of the drawings

In the drawings:

- Figure 1 schematically shows a driving circuit for an emitter-switching configuration for resonant applications according to the prior art;

- Figure 2 schematically shows the trend of waveforms typical of a rice cooker device according to the prior art;

- Figures 3 and 4 schematically show the trends of the output features of an IGBT transistor and of an emitter-switching configuration;

- Figure 5 schematically shows a driving circuit for a bipolar transistor in the emitter-switching configuration for resonant applications according to the invention;

- Figures 6 and 7 show the trends of waveforms obtained with a known driving circuit;

- Figures 8 and 9 show the trends of waveforms obtained by rice cooker devices by using the driving circuit according to the invention and shown in figure 5.

Detailed description

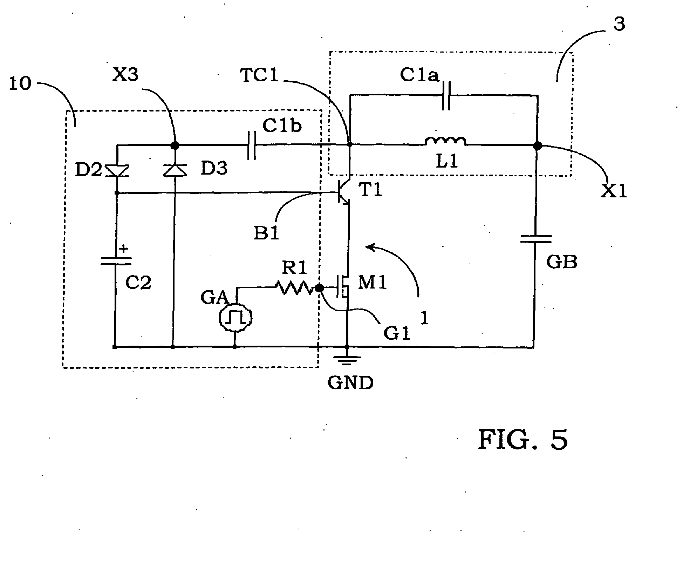

With reference to the figures, and particularly to figure 5, a driving circuit for an emitter-switching configuration with resonant load according to the invention has been globally and schematically indicated with 10. Elements being structurally and functionally identical to those described with reference to the prior art and to figure 1 have been given the same numeral references.

Particularly, the driving circuit 10 according to the invention is associated to an emitter-switching configuration 1 comprising a bipolar transistor T1 arid a MOS transistor M1 being cascode-connected to each other, connected between a load 3 and a voltage reference, particularly the ground GND.

As it has been seen with reference to the prior art, the emitter-switching configuration 1 provides that the bipolar transistor T1 is of the HV (High Voltage) type, i.e. a high breakdown voltage transistor, while the MOS transistor M 1 is of the LV (Low Voltage) type, i.e. a low breakdown voltage transistor.

The bipolar transistor T1 has a collector terminal connected to the load 3 and a control or base terminal B1 connected to the driving circuit 10.

The load 3 is of the resonant type and it comprises an inductor L1 corresponding to the primary of a transformer and a first capacitor C1a inserted, in parallel with the inductor L1, between the collector terminal of the bipolar transistor T1 and a first circuit node X1, connected in turn to a generator GB of a supply voltage Vcc, applied to the supply circuit node X1.

The MOS transistor M1 has in turn a control or gate terminal connected to the driving circuit 10.

The driving circuit 10 comprises:

- a first resistive element R1 connected to the gate terminal G1 of the MOS transistor M1 and, by means of a voltage pulse generator GA, to ground GND; and

- an electrolytic capacitor C2 connected between the base terminal B 1 of the bipolar transistor T1 and the ground GND and having at the terminals thereof a voltage value equal to VB;

Advantageously according to the invention, the driving circuit 10 comprises a further capacitor C1b inserted between the collector terminal TC1 of the bipolar transistor T1 and a second circuit node X3, as well as a first D2 and a second D3 diodes, inserted between the second circuit node X3 and, respectively, the base terminal B1 of the bipolar transistor T1 and the ground GND.

Particularly, the first diode D2 has a cathode terminal connected to the base terminal B1 and an anode terminal connected to the second circuit node X3, while the second diode D3 has a cathode terminal connected to the second circuit: node X3 and an anode terminal connected to ground GND.

Therefore, advantageously according to the invention, the driving circuit 10 exploits, in order to supply the base terminal B1 of the bipolar transistor T1, the energy which was transferred from the inductor L1 to the capacitor C1 in known devices in the first part of the turn-off step [OFF].

Particularly, with reference to the circuit of figure 1, it is worth observing that it is possible to connect the first capacitor C1 between the collector terminal TC1 of the bipolar transistor T1 and the ground GND, without making any change from the dynamic point of view and concerning the system operation comprising the emitter-switching configuration 1 and the resonant load 3.

It must be also observed that a capacitor inserted between the collector terminal and the ground GND is equal to a capacitor inserted between the collector terminal and the base terminal since the capacitor C2 is a high electrolytic capacitor with respect to capacitors C1a and C1b, therefore, in the case shown in figure 5, the base terminal B1 can be considered as connected to ground GND.

It is thus evident that capacitors C1a and C1b are in parallel and that they are chosen so as to correspond to the capacity value of the capacitor C1 of the resonant load 3 according to known solutions, as the one shown in figure 1.

Advantageously according to the invention, the prior art resonant capacitor C1 division into capacitors C1a and C1b is used to conveniently supply the base terminal.

To achieve the correct operation of the bipolar transistor T1, the driving circuit 10 causes the current flowing in the capacitor C1b during the charge step to flow also in the electrolytic capacitor C2, while the opposite sign current, which discharges the capacitor C1b, does not discharge that electrolytic capacitor C2 due to the presence of diodes D2 and D3 being connected to the second circuit node X2 oppositely to each other.

Always with reference to figure 5, it is possible to describe the driving method according to the invention.

Particularly, the method according to the invention allows the control terminal B1 of the bipolar transistor T1 in the emitter-switching configuration to be driven and it provides the following steps of:

- applying a first voltage value VB by means of the capacitor C2 to the control terminal B1; and

- keeping the electrolytic capacitor C2 charged by means of a current flowing in the capacitor C1b, due to the presence of diode D2;

- preventing a capacitor C1b discharge current from flowing also in the electrolytic capacitor C2, due to the presence of diode D3.

Advantageously according to the invention, diodes D2 and D3 are chosen with a low breakdown voltage value (equal to about 20 V).

By way of example, in order to show the efficacy of the driving circuit according to the invention, it has been chosen to use a rice cooker device with an operating frequency of 35 kHz and highest collector current reaching about 40 A, but the following considerations can be applied to any circuit having similar features to those indicated with reference to the prior art.

It is worth noting that in the system of figure 1 according to the prior art, during the discharge step [OFF], the magnetic energy stored, during the conduction step [ON], in the inductor L1 is transferred to the capacitor C1 as electrostatic energy, so as to be then transferred again to the inductor L1.

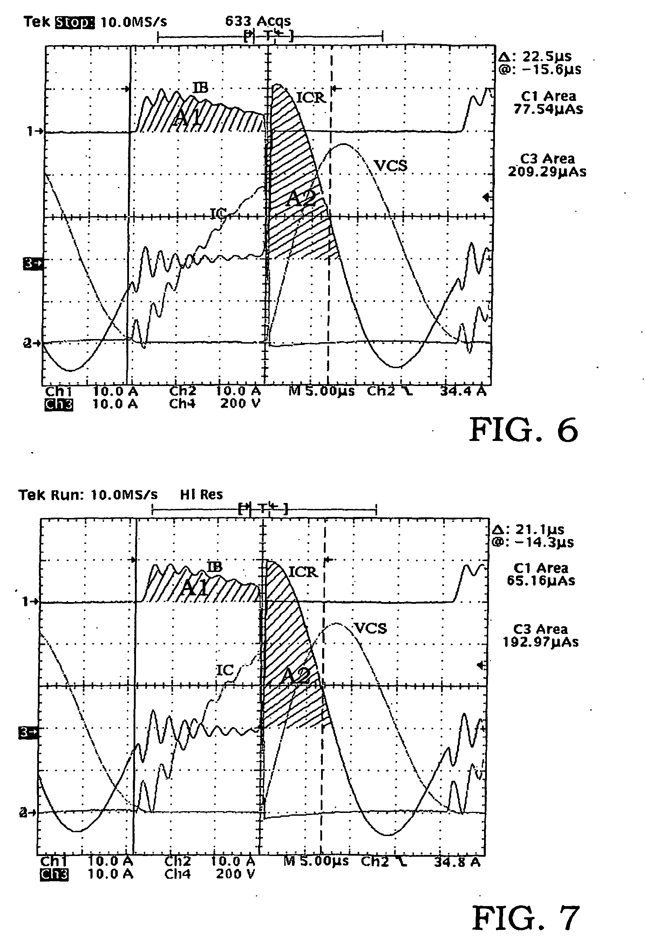

Figures 6 and 7 represent waveforms concerning a driving circuit according to the prior art in the case in which the capacitor C1 is in parallel with the inductor L1 or between the collector terminal and the ground, respectively.

Particularly, it can be observed that the current flowing, in the charge step, on the capacitor C1 is the same in both cases.

It can also be noted in figure 6 that the charge serving to supply the base terminal B1 of the bipolar transistor T1 for each cycle during the conduction is in the range of 70 $\mu$C (area A1), while the amount of charge available is the one charging the capacitor C1 of figure 1 and it is equal to about 200 $\mu$C (area A2). In other words, the amount of charge required to supply the base terminal B 1 is about a quarter of the total charge stored on the capacitor C1.

Advantageously according to the invention, the driving circuit 10 replaces the capacitor C1 with the parallel connection of two capacitors C1a and C1b, being both smaller than C1 and particularly the one having a value equal to a quarter of the other, so that the sum gives however the value of the capacitor C1 of the driving circuit according to the prior art. The capacitor C1b connected between the collector and base terminals will have to be the lower capacitor.

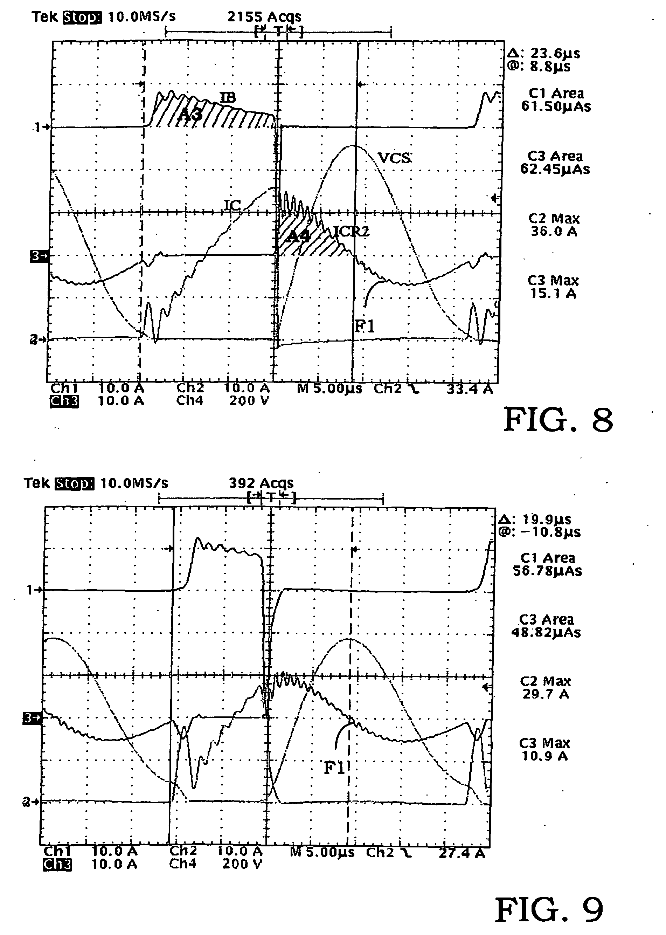

In this way, the situation of figures 8 and 9 is achieved, wherein the curve F1 is the current flowing on the capacitor C1b, whose positive part charges the capacitor C2 and allows thus the base terminal B1 of the bipolar transistor T1 to be supplied. It is worth noting that, advantageously according to the invention, areas A3 and A4 are in this case identical, as underlined in figure 8.

Particularly, the driving circuit 10 according to the invention provides the base terminal B1 with an amount of charge being proportional to the highest current of the collector terminal TC1, as shown in figures 8 and 9 for a driving circuit used in a rice cooker device.

In figure 8, for a high power rice cooker device, the highest collector current is equal to about 38 A and the charge stored on the electrolytic capacitor C2, and then used to drive the base terminal B1, is equal to 62 $\mu$C. In figure 8, for a low power rice cooker device, the highest collector current is equal to 30 A and the charge stored on the electrolytic capacitor C2 is equal to about 50 $\mu$C.

**Claims**

1. A driving circuit for a control terminal (B1) of a bipolar transistor (T1) inserted, in the emitter-switching configuration, between a resonant load (3) and a voltage reference (GND), said driving circuit comprising at least a capacitor (C2) connected between said control terminal (B1) and said voltage reference (GND), **characterised in that** it further comprises:

   - an additional resonance capacitor (C1b) connected between a collector terminal (TC1) of said bipolar transistor (T1) and a circuit node (X3);
   - a first diode (D2) inserted between said circuit node (X3) and said control terminal (B1); and
   - a second diode (D3) inserted between said circuit node (X3) and said voltage reference (GND).

2. A driving circuit according to claim 1, **characterised in that** said first (D2) and second (D3) diodes are connected to said circuit node (X3) oppositely to each other.

3. A driving circuit according to claim 2, **characterised in that** said first diode (D2) has a cathode terminal connected to said control terminal (B1) and an anode terminal connected to said circuit node (X3).

4. A driving circuit according to claim 1, **characterised in that** said second diode (D3) has a cathode terminal connected to said circuit node (X3) and an anode terminal connected to said voltage reference (GND).

5. A driving circuit according to claim 1, **characterised in that** said first (D2) and second (D3) diodes have a breakdown voltage value equal to 20 V.

6. A driving method for a control terminal (B1) of a bipolar transistor (T1) inserted, in the emitter-switching configuration (1), between a resonant load (3) and a voltage reference (GND) **characterised in that** it provides the steps of:

   - applying a first voltage value (VB) by means of an electrolytic capacitor (C2) to said control terminal (B1); and

- keeping said electrolytic capacitor (C2) charged by means of a current flowing in a resonance capacitor (C1b) connected to a collector terminal (TC1) of said bipolar transistor (T1), due to the presence of a first diode (D2) connected between said resonance capacitor (C1b) and said electrolytic capacitor (C2);

- preventing a discharge current of said resonance capacitor (C1b) from flowing also in said electrolytic capacitor (C2), due to the presence of a second diode (D3) inserted between said resonance capacitor (C1b) and said voltage reference (GND).

**Patentansprüche**

1. Ansteuerschaltung für einen Steueranschluss (B1) eines Bipolartransistors (T1), der in der Emitterschaltkonfiguration zwischen einer Resonanzlast (3) und einer Spannungsreferenz (GND) eingefügt ist, wobei die Ansteuerschaltung zumindest einen Kondensator (C2) umfasst, der zwischen dem Steueranschluss (B1) und der Spannungsreferenz (GND) angeschlossen ist, **dadurch gekennzeichnet, dass** sie darüber hinaus umfasst:

   - einen zusätzlichen Resonanzkondensator (C1b), der zwischen einem Kollektoranschluss (TC1) des Bipolartransistors (T1) und einem Schaltungsknoten (X3) angeschlossen ist;
   - eine erste Diode (D2), die zwischen dem Schaltungsknoten (X3) und dem Steueranschluss (B1) eingefügt ist; und
   - eine zweite Diode (D3), die zwischen dem Schaltungsknoten (X3) und der Spannungsreferenz (GND) eingefügt ist.

2. Ansteuerschaltung nach Anspruch 1, **dadurch gekennzeichnet, dass** die erste (D2) und zweite (D3) Diode einander entgegengesetzt an den Schaltungsknoten (X3) angeschlossen sind.

3. Ansteuerschaltung nach Anspruch 2, **dadurch gekennzeichnet, dass** die erste Diode (D2) einen Kathoden-Anschluss hat, der an den Steueranschluss (B1) angeschlossen ist, und einen Anoden-Anschluss, der an den Schaltungsknoten (X3) angeschlossen ist.

4. Ansteuerschaltung nach Anspruch 1, **dadurch gekennzeichnet, dass** die zweite Diode (D3) einen Kathoden-Anschluss hat, der an den Schaltungsknoten (X3) angeschlossen ist, und einen Anoden-Anschluss, der an die Spannungsreferenz (GND) angeschlossen ist.

5. Ansteuerschaltung nach Anspruch 1, **dadurch ge-**

kennzeichnet, dass** die erste (D2) und zweite (D3) Diode einen Durchbruchspannungswert von 20 V haben.

6. Ansteuerverfahren für einen Steueranschluss (B1) eines Bipolartransistors (T1), der in der Emitterschaltkonfiguration (1) zwischen einer Resonanzlast (3) und einer Spannungsreferenz (GND) eingefügt ist, **dadurch gekennzeichnet, dass** es folgende Schritte vorsieht:

   - Anlegen eines ersten Spannungswerts (VB) mittels eines Elektrolytkondensators (C2) an den Steueranschluss (B1); und
   - den Elektrolytkondensator (C2) mittels einem in einem Resonanzkondensator (C1b) fließenden Strom im geladenen Zustand zu halten, welcher Resonanzkondensator an einen Kollektoranschluss (TC1) des Bipolartransistors (T1) angeschlossen ist, aufgrund des Vorhandenseins einer ersten Diode (D2), die zwischen dem Resonanzkondensator (C1b) und dem Elektrolytkondensator (C2) angeschlossen ist;
   - Verhindern, dass auch ein Entladestrom des Resonanzkondensators (C1b) im Elektrolytkondensator (C2) fließt, aufgrund des Vorhandenseins einer zweiten Diode (D3), die zwischen dem Resonanzkondensator (C1b) und der Spannungsreferenz (GND) eingefügt ist.

**Revendications**

1. Circuit de commande pour une borne de commande (B1) d'un transistor bipolaire (T1) inséré, en configuration émetteur commuté, entre une charge résonnante (3) et une référence de tension (GND), ledit circuit de commande comprenant au moins un condensateur (C2), connecté entre ladite borne de commande (B1) et ladite référence de tension (GND), **caractérisé en ce qu'**il comprend en outre :

   - un condensateur à résonance (C1b) supplémentaire, connecté entre une borne de collecteur (TC1) dudit transistor bipolaire (T1) et un noeud de circuit (X3) ;
   - une première diode (D2) insérée entre ledit noeud de circuit (X3) et ladite borne de commande (B1) ; et
   - une deuxième diode (D3) insérée entre ledit noeud de circuit (X3) et ladite référence de tension (GND).

2. Circuit de commande selon la revendication 1, **caractérisé en ce que** lesdites première (D2) et deuxième (D3) diodes sont connectées audit noeud de circuit (X3), en opposition l'une de l'autre.

**3.** Circuit de commande selon la revendication 2, **caractérisé en ce que** ladite première diode (D2) a une borne de cathode connectée à ladite borne de commande (B1), et une borne d'anode connectée audit noeud de circuit (X3).

**4.** Circuit de commande selon la revendication 1, **caractérisé en ce que** ladite deuxième diode (D3) a une borne de cathode connectée audit noeud de circuit (X3), et une borne d'anode connectée à ladite référence de tension (GND).

**5.** Circuit de commande selon la revendication 1, **caractérisé en ce que** lesdites première (D2) et deuxième (D3) diodes ont une valeur de tension de claquage égale à 20 V.

**6.** Procédé de commande pour une borne de commande (B1) d'un transistor bipolaire (T1) inséré, en configuration émetteur commuté (1), entre une charge résonnante (3) et une référence de tension (GND), **caractérisé en ce qu'**il fournit les étapes consistant à :

    - appliquer une première valeur de tension (VB) au moyen d'un condensateur électrolytique (C2) à ladite borne de commande (B1) ; et
    - maintenir ledit condensateur électrolytique (C2) chargé au moyen d'un courant circulant dans un condensateur à résonance (C1b), connecté à une borne de collecteur (ICI) dudit transistor bipolaire (T1), glace à la présence d'une première diode (D2), connectée entre ledit condensateur à résonance (C1b) et ledit condensateur électrolytique (C2) ;
    - empêcher un courant de décharge dudit condensateur à résonance (C1b) de circuler également dans ledit condensateur électrolytique (C2), grâce à la présence d'une deuxième diode (D3) insérée entre ledit condensateur à résonance (C1b) et ladite référence de tension (GND).

FIG. 1
PRIOR ART

FIG. 2
PRIOR ART

**IGBT Output Characteristics**

FIG. 3
PRIOR ART

**Emitter-Switching Output Characteristics**

FIG. 4
PRIOR ART

FIG. 5

FIG. 6

FIG. 7

11

FIG. 8

FIG. 9